Europäisches Patentamt

European Patent Office

Office européen des brevets

(11) Veröffentlichungsnummer : **0 046 500**
**B1**

# (12) EUROPÄISCHE PATENTSCHRIFT

(45) Veröffentlichungstag der Patentschrift :
**05.10.83**

(51) Int. Cl.³ : **G 06 F 11/26**, G 11 C 19/00

(21) Anmeldenummer : **81105493.1**

(22) Anmeldetag : **14.07.81**

(54) **Schieberegister für Prüf- und Test-Zwecke.**

(30) Priorität : **09.08.80 DE 3030299**

(43) Veröffentlichungstag der Anmeldung :
**03.03.82 Patentblatt 82/09**

(45) Bekanntmachung des Hinweises auf die Patenterteilung : **05.10.83 Patentblatt 83/40**

(84) Benannte Vertragsstaaten :
**DE FR GB IT**

(56) Entgegenhaltungen :
**US A 3 239 764**

(73) Patentinhaber : **IBM DEUTSCHLAND GMBH**
**Pascalstrasse 100**
**D-7000 Stuttgart 80 (DE)**
**DE**
**International Business Machines Corporation**
**Old Orchard Road**
**Armonk, N.Y. 10504 (US)** ·
**FR GB IT**

(72) Erfinder : **Blum, Arnold**
**Finkenweg 16**
**D-7261 Gechingen (DE)**

(74) Vertreter : **Rudolph, Wolfgang**
**Schönaicher Strasse 220**
**D-7030 Böblingen (DE)**

Schieberegister für Prüf- und Test-Zwecke

Die Erfindung betrifft ein Schieberegister nach dem Oberbegriff des Anspruchs 1.

Mit fortschreitender Integrierung bis zur hochgradigen Integrationstechnik (LSI) wurde und wird die direkte Zugänglichkeit zu einer Schaltungsgruppe in einer physikalischen Einheit (z. B. einem Chip, einem Modul) immer stärker eingeschränkt. Diese Sachlage ist sowohl auf die stark ansteigende Anzahl von Schaltungen innerhalb der LSI-Einheit als auch auf die mikroskopischen Abmessungen zurückzuführen, die diese Schaltungen heute haben. Das Ausprüfen dieser Schaltungen ist damit zu einem Hauptproblem bei der Herstellung von hochintegrierten Schaltungen geworden.

Das Ausprüfen einer LSI-Einheit wird nämlich dadurch erschwert, daß unzugängliche Speicherelemente und Verriegelungsschaltungen vorhanden sind, die regulär in die logischen Kombinationsnetzwerke eingebettet sind. Ohne aber die logischen Zustände dieser eingebetteten Verriegelungen sicher prüfen und untersuchen zu können, kann man auch die zugehörigen logischen Netzwerke nicht prüfen. Trotzdem kann man aber sowohl bei der Herstellung als auch beim Betrieb nicht auf eine zuverlässige und sorgfältige Prüfung aller LSI-Bauelemente bzw. -Einheiten verzichten.

Einige nachfolgend diskutierte US-Patentschriften aus der letzten Zeit sehen zwar Systemkonstruktionsverfahren und -disziplinen vor, die die oben gestellten Fragen beantworten sollen. Sie alle laufen unter dem Titel « LSSD » (Levelempfindliche Abfragekonstruktion). Eine Gemeinsamkeit dieser bekannten Lösungen besteht darin, daß eine eingebaute Schaltung für jede LSI-Einheit vorgeschrieben wird, durch die der ganze logische Zustand der Einheit in der Prüfung explizit festgelegt und/oder durch Anwendung bestimmter Eingabe- und Ausgabeverfahren an einer begrenzten Anzahl von E/A-Anschlüssen untersucht werden kann. Diese Forderungen lassen sich dadurch verwirklichen, daß man jeder Verriegelung des logischen Systems in der Einheit eine Schieberegistermöglichkeit gibt und daraufhin diese Schieberegisterverriegelungen (SRL) zu einem oder mehreren Schieberegister-Datenkanälen zusammenschließt bzw. organisiert, deren Anschlußstufen von außen zugänglich sind.

Detaillierte Operationen mit dieser SRL-Einrichtung für verschiedene Prüfgesichtspunkte werden in der US-PS 3 761 695 und in den Fign. 7 bis 9 der US-PS 3 784 907 angegeben.

Die wichtigsten Punkte lassen sich wie folgt zusammenfassen : Im Prüfbetrieb werden bestimmte gewünschte logische Prüfmuster seriell eingegeben und an die entsprechenden Verriegelungsstellen verschoben, wenn die Einheit im Schiebebetrieb betrieben wird, d. h. durch Zurückhaltung des System-Taktes und Einschaltung der Schiebetaktimpulse an der Einheit.

Wenn dies geschieht, liefern die Verriegelungszustände der einzelnen Schaltungen die gewünschten Impulse zum Prüfen der zugehörigen logischen Netzwerke. Jetzt werden die Prüfmuster durch die Netzwerke weitergeleitet, durch Ausführung eines oder mehrerer Schritte des Funktionsbetriebes, d. h. durch eine gewöhnliche System-Takterregung. Die Antwortmuster der logischen Netzwerke auf die angelegten Impulse werden jetzt durch die Systemverriegelungen auf bekannte Weise abhängig von bestimmten Zuständen in der maschinellen Konstruktion festgehalten, die oft die ursprünglich eingegebenen Prüfmuster ersetzen. Zur Untersuchung kehrt man in den Schiebebetrieb zurück und gibt diese Antwortmuster aus. Durch die in der Praxis übliche Benutzung konventioneller Schieberegister für die SRL' s erhält man die Möglichkeit auf Kosten der Hardware Prüfen und Testen zu können, was in den meisten Fällen eine beträchtliche wirtschaftliche Belastung darstellt (die Erfahrung zeigt, daß die Hardware wenigstens 10 bis 35 % und mehr teurer werden kann). Dies ist hauptsächlich darauf zurückzuführen, daß jeder Systemverriegelung eine zweite Verriegelung hinzugefügt werden muß, damit sie auf bekannte Weise zu einer arbeitsfähigen SRL-Stufe wird.

Konventionelle Schieberegister benutzen deshalb zwei Verriegelungen für jede Schieberegisterstufe. Einschiebe- und Ausschiebeoperationen werden durch paralleles Anlegen einer zweiphasigen Taktfolge vorgenommen.

Das in der US-PS 3 783 254 gezeigte Schieberegister verwendet zwei Gleichstrom-Verriegelungsschaltungen für jede Schieberegisterstufe, Einschiebe- und Ausschiebeoperationen erfolgen durch paralleles Anlegen eines zweiphasigen Taktsystems an eine erste und zweite Verriegelungsschaltung einer jeden Stufe des Schieberegisters.

Um den Aufwand der doppelten Verriegelungsschaltungen zu verringern, wurde durch die DE-OS 2 723 594 ein Schieberegister für Prüf- und Testzwecke bekannt, das bei gleicher Funktion jedoch nur noch halb so viele Verriegelungsschaltungen benötigt. Dies wird dadurch erreicht, daß jedem Schaltkreis oder jeder Schaltkreisgruppe für eine bestimmte logische Funktion oder Speicherfunktion eine Verriegelungsschaltung zugeordnet ist, daß diese Verriegelungsschaltungen gleichzeitig Stufen des Schieberegisters sind, das über seinen Eingang Prüf- bzw. Testinformationen erhält und an seinem Ausgang bestimmte Bitmuster in Abhängigkeit der eingegebenen Prüf- und Testinformationen sowie des Zustands des zu prüfenden integrierten Schaltkreises abgibt, und daß die Verriegelungsschaltungen abwechselnd mit A- und B-Impulsen innerhalb eines einen Testkanal bildenden Schieberegisters in Abhängigkeit einer Schiebe-Takt-Leitsteuerung fortgeschaltet werden, wodurch die verschiedenen Verriegelungsschaltkreise zu einer Taktzeit (A oder B) einzeln oder mehrmals aktiv werden. Die Information wird dadurch im Schieberegister komprimiert und auseinandergezogen nach Art eines Akkordeons.

Diese Lösung hat jedoch immer noch einen relativ hohen Anteil an Hilfsschaltkreisen, nämlich die Hälfte im Verhältnis zu den Hauptschaltkreisen, und darüber hinaus ist eine sehr aufwendige Leitungsführung und Leitungssteuerung erforderlich, die die Integration und Testmöglichkeiten wesentlich einschränken.

Der Erfindung liegt deshalb die Aufgabe zugrunde, ein Schieberegister für Prüf- und Testzwecke auf Speicher- und Logik-Chips zu schaffen, das ohne Hilfsschaltkreise trotz Zwischenspeicherung der Information auskommt und außerdem auch eine einfachere Leitungsführung als die bisher bekannten aufweist.

Die erfindungsgemäße Lösung besteht im Kennzeichen des Anspruchs 1.

Ausgestaltungen dieser Lösung sind in den Ansprüchen 2 bis 5 charakterisiert.

Durch die kaskadenartige Anordnung der Hauptverriegelungs-Schaltungen MLT und die Verwendung eines dieser Hauptverriegelungs-Schaltungen in der ersten Teil-Kaskade gewissermaßen als Hilfsverriegelungs-Schaltung und danach unter Heranholen der freiwerdenden Hauptverriegelungs-Schaltungen als Hilfsverriegelungs-Schaltungen ist es möglich, ohne eine tatsächlich vorhandene Hilfsverriegelungs-Schaltung eine Zwischenspeicherung vorzunehmen, d. h. eine Verschiebung von Daten in einer solch aufgebauten Schiebekette vorzunehmen, ohne daß auf eine Zwischenspeicherung verzichtet wird. Daraus ergibt sich, daß keine kritischen Zeitbedingungen für die Steuerimpulse eingehalten werden müssen und daß keine aufwendigen Schaltungen zur Steuerung des Schieberegisters vorhanden sein müssen. Die Einsparung aller sonst erforderlichen Hilfsverriegelungs-Schaltungen sowie der Verbindungsleitungen zwischen diesen Hilfsverriegelungs-Schaltungen und den Hauptverriegelungs-Schaltungen sind die Folge, ohne daß die Funktionstüchtigkeit in irgendeiner Weise darunter leidet bzw. an die sonstigen Zeitbedingungen und Schaltungen hohe Anforderungen gestellt werden müssen.

Die Erfindung wird nun anhand eines Ausführungsbeispieles, das in den Zeichnungen dargestellt ist, näher beschrieben.

Es zeigen :

Figur 1 ein Blockschaltbild eines Schieberegisters ;

Figur 2 eine detaillierte Schaltung eines Schieberegisters ;

Figur 3 ein Zeitdiagramm für die Auseingabeoperation des Schieberegisters nach Fig. 2 ;

Figur 4 ein Zeitdiagramm für die Schiebe-Ausgabeoperation des Schieberegisters nach Fig. 2 und

Figur 5 ein Zeitdiagramm für eine zweite Version der Eingabeoperation des Schieberegisters nach Fig. 2.

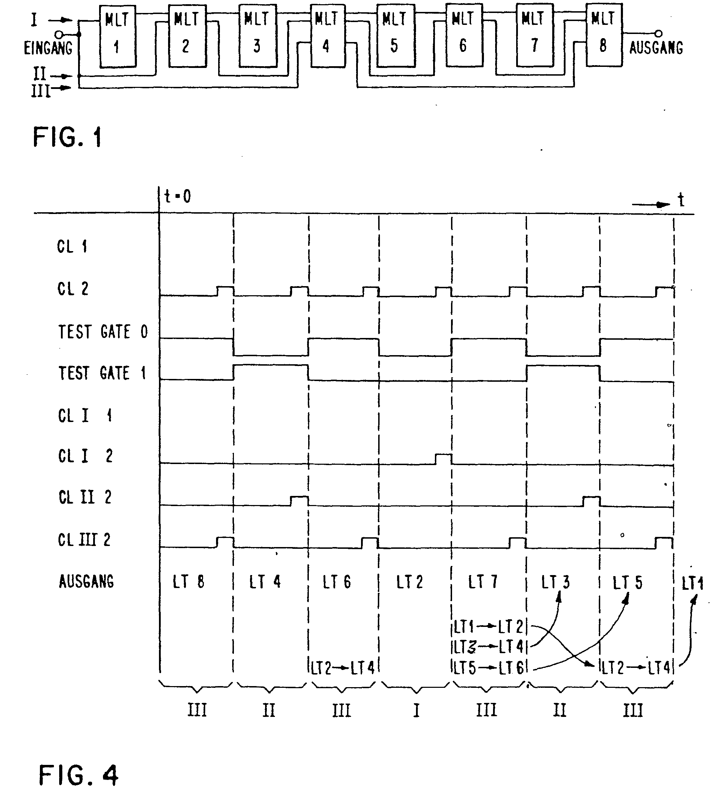

In Fig. 1 ist ein Schieberegister dargestellt, das ein Teil eines großen Schieberegisters für den Datenfluß innerhalb einer Prozessor-Einheit sein kann. Zum Zwecke der einfachen Überschaubarkeit wurden in diesem Prinzipschaltbild alle Taktsignale und die diese Taktsignale führenden Leitungen weggelassen.

Das in Fig. 1 dargestellte Schieberegister besteht nun aus acht Hauptverriegelungs-Schaltungen MLT1 bis MLT8 ohne jede Hilfsverriegelungs-Schaltung wie sie bei den bekannten Schieberegistern erforderlich sind. Die Hauptverriegelungs-Schaltungen MLT sind dabei kaskadenweise zu Schiebeketten so zusammengeschaltet, daß in der Schiebekette I alle Hauptverriegelungs-Schaltungen enthalten sind und in der Schiebekette II nur jede zweite Hauptverriegelungs-Schaltung MLT und in der Schiebekette III jede vierte Hauptverriegelungs-Schaltung usw., bis in der letzten Schiebekette n nur noch zwei Hauptverriegelungs-Schaltungen MLT enthalten sind.

Obwohl in Fig. 1 die einzelnen Taktsignale und Taktleitungen nicht angegeben sind, soll hier erwähnt sein, daß die einzelnen Schiebeketten I bis III jeweils nur einzeln, d. h. zeitlich nacheinander, angesteuert werden.

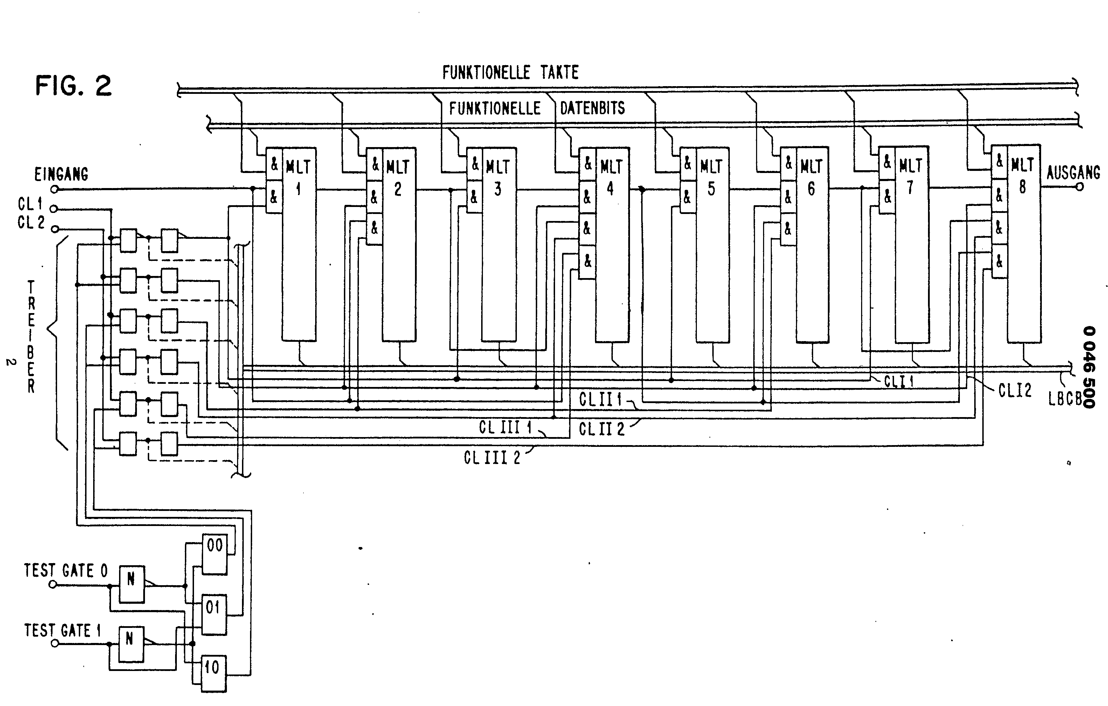

In Fig. 2 ist nun die Schiebekette nach Fig. 1, bestehend aus acht Hauptverriegelungs-Schaltungen MLT1 bis MLT8 mit der zugehörigen Schiebelogik, d. h. den Taktleitungen und zugehörigen Schaltkreisen detaillierter dargestellt. Wie aus Fig. 2 hervorgeht, hat jede Hauptverriegelungs-Schaltung MLT für jede ihr zugeordnete Schiebekette einen separaten Schiebe-Dateneingang. Der Eingang wird durch UND-Schaltungen, die jeder Hauptverriegelungs-Schaltung vorgeschaltet sind, gebildet. Neben diesen Schiebe-Dateneingängen für die zugeordneten Schiebeketten gehen außerdem noch die rein funktionellen Dateneingänge an den Hauptverriegelungs-Schaltungen MLT vorgeschaltete UND-Schaltungen.

Zu erwähnen ist noch, daß bei diesem Schieberegister die am weitesten links liegende Hauptverriegelungs-Schaltung MLT1 den Schiebeeingang des gesamten Registers bildet und die am weitesten rechts liegende Hauptverriegelungs-Schaltung MLT8 den Ausgang des gesamten Schieberegisters.

Links unten im Schaltbild nach Fig. 2 sind die Eingangssignale Testgate 0 und Testgate 1 auf ein Netzwerk geführt, das bestimmt, welche der Schiebeketten I, II oder III zum Verschieben der in ihnen gespeicherten Daten angesteuert wird. Die beiden binär codierten Signale Testgate 0 und Testgate 1 auf den entsprechenden Leitungen werden in der Schaltung, bestehend aus zwei Negatoren N und nachgeschalteten logischen Schaltungen 00, 01 und 10 so logisch kombiniert, daß die Ausgangssignale der letztgenannten Schaltungen bei der Kombination 00 die Schiebekette I selektieren, bei der Kombination 01 die Schiebekette II und bei der Kombination 10 die Schiebekette III. Zu diesem Zwecke sind die Ausgänge der genannten logischen Schaltungen 00, 01 und 10 mit den Eingängen von Treiberschaltungen verbunden, an deren Eingängen die Taktimpulse CL1 und CL2 liegen. Das heißt mit anderen Worten, daß die Taktsignale CL1 und CL2 *über die Treiberschaltungen nur zu ganz* bestimmten zu einer Schiebekette I, II oder III gehörenden Hauptverriegelungs-Schaltungen MLT zu bestimmten Zeitintervallen gelangen, wodurch die einzelnen Teil-Kaskaden bzw. Schiebeketten I bis III gebildet werden.

Wichtig ist, daß nun während einer Schiebeoperation innerhalb jeder Schiebekette I, II oder III die ungeraden innerhalb der Schiebekette gezählt Hauptverriegelungs-Schaltungen als Schiebe-Hauptverriegelungen bestimmt bzw. festgelegt werden und mit dem Verschiebetakt CL ... 1 gesetzt werden, während die mit geraden Zahlen bezeichneten Hauptverriegelungs-Schaltungen wie Schiebehilfsverriegelungs-Schaltungen behandelt werden und mit dem Schiebetakt CL ... 2 geschaltet werden. Durch dieses System ist es möglich, daß trotz Nichtvorhandenseins einer physikalischen Hilfsverriegelungs-Schaltung das in Fig. 2 gezeigte Schieberegister den Gesetzen eines normalen Schieberegisters voll entspricht, d. h., daß beim jeweiligen Schiebevorgang für die zu verschiebende Information tatsächlich im Zeitpunkt des Verschiebens eine Hilfsverriegelungs-Schaltung vorhanden ist, so daß die zu verschiebende Information tatsächlich zwischengespeichert werden kann.

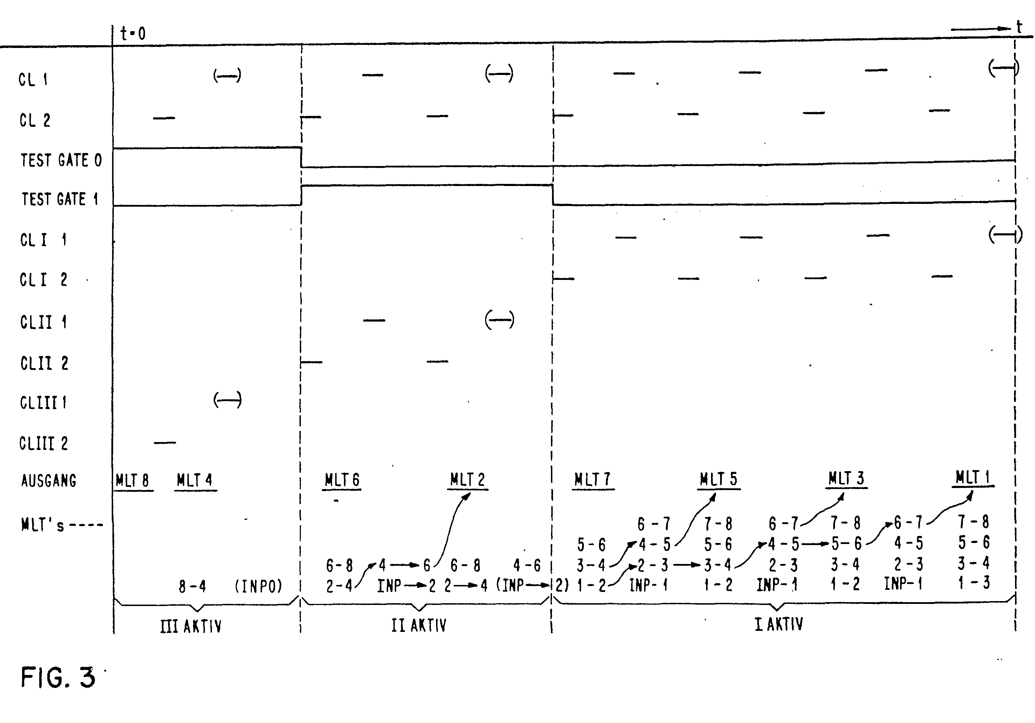

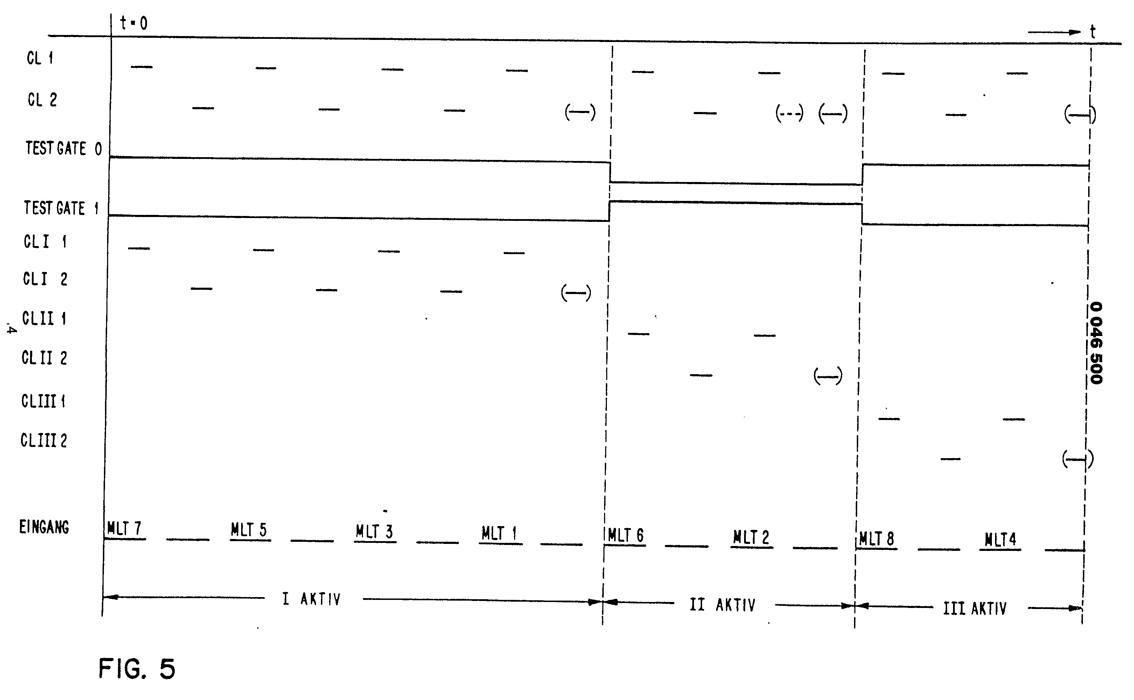

In Fig. 3 ist nun ein Zeit- und Impulsdiagramm für das Heraus- und Hineinschieben von Informationen aus allen acht dargestellten Hauptverriegelungs-Schaltungen MLT1 bis MLT8 des Schieberegisters nach Fig. 2 dargestellt. Wie daraus zu ersehen ist, bestimmt der Zustand der Signale Testgate 0 und Testgate 1 die Schiebezeitintervalle der jeweiligen Schiebeketten I bis III. Bei dem dargestellten symmetrischen Ablauf der beiden Schiebetakte CL1 und CL2 erscheinen dann am Ausgang des Schieberegisters die Inhalte aller im Datenflußregister vorhandenen Hauptverriegelungs-Schaltungen in der angegebenen Reihenfolge. Im untersten Bereich des Zeitdiagramms nach Fig. 3 werden die jeweiligen Zustände der Hauptverriegelungsschaltungen in den jeweiligen Schiebeketten I bis III dargestellt. In Fig. 4 wird ein Impuls- und Zeitdiagramm angegeben, das eine schnellere Schiebeoperation mit Hilfe des Schieberegisters nach Fig. 2 ermöglicht. Bei diesem Zeit- und Impulsschema ist nur der Verschiebetakt CL2 aktiv. Die Signale Testgate 0 und Testgate 1 aktivieren hier in einer anderen Reihenfolge die zu den einzelnen Schiebeketten I bis III gehörenden Hauptverriegelungs-Schaltungen MLT1 bis MLT8. Bei dieser Methode bleiben beim Herausschieben von Informationen aus dem Schieberegister sogar die Informationen der ungeraden Hauptverriegelungs-Schaltungen MLT1, MLT3, ..., erhalten, d. h. die darin gespeicherten Informationen gehen nicht verloren, weil aus keiner Hauptverriegelungs-Schaltung Information in die Schaltungen MLT1, MLT3, ..., geschoben wird.

Ein gleichzeitiges Eingeben neuer Informationen in das Schieberegister wird wegen des Nichtaktivierens des Schiebetaktes CL1 vermieden. Es soll hier bemerkt werden, daß dieses Verhalten auch zu Diagnosezwecken innerhalb einer Datenverarbeitungsanlage sehr vorteilhaft ausgenutzt werden kann. Außerdem reduziert sich bei diesem Verfahren die Anzahl der Verschiebetakte CL um die Hälfte.

In Fig. 5 ist nun ein weiteres Zeit- und Impulsdiagramm für das Eingeben in alle Datenflußregister-Hauptverriegelungs-Schaltungen bei symmetrischem Ablauf der beiden Verschiebetakte CL1 und CL2 dargestellt. Am Eingang werden die in die Hauptverriegelungs-Schaltungen MLT hineinzugebenden Werte für die jeweiligen Hauptverriegelungs-Schaltungen in der angegebenen Reihenfolge angelegt. Die Steuersignale Testgate 0 und Testgate 1 bestimmen wiederum, welche Schiebekette gerade aktiv ist und zwar bedingt durch das Durchlassen der entsprechenden Schiebesignale CL ... 1 und CL ... 2, wobei für die Punkte I, II oder III ... je nach Struktur des Schieberegisters steht.

Wie gezeigt, führt diese Lösung zu einer Halbierung der Verriegelungsschaltungen innerhalb eines Schieberegisters (weil keine Hauptverriegelungs-Schaltung eine fest zugeordnete Hilfsverriegelungs-Schaltung besitzt), so daß auf dem Halbleiterchip Platz eingespart werden kann, der für Speicherschaltkreise oder logische Schaltkreise innerhalb des Systems, das auf dem Halbleiterchip aufgebracht ist, nutzbringender verwendet werden kann. Dies ist insbesondere dann von Vorteil, wenn ein vollständiger Mikroprozessor auf einem Chip angeordnet ist, da hier der zur Verfügung stehende Platz äußerst beschränkt ist. Die Testfunktionen und -zeiten werden durch dieses Konzept nicht eingeschränkt, so daß die volle Prüf- und Testfähigkeit eines Halbleiterchips bzw. eines ganzen Systems erhalten bleibt.

**Ansprüche**

1. Schieberegister für Prüf- und Test-Zwecke auf Speicher- und Logik-Chips, dessen gespeicherter Inhalt durch Taktimpulse verschoben wird und das aus Verriegelungsschaltungen, die sich auf dem Speicher- bzw. Logik-Chip befinden, besteht, dadurch gekennzeichnet, daß $2^n$ Verriegelungsschaltungen (MLT) derart kaskadenweise zu n Schiebeketten (I bis n) zusammengeschaltet sind, daß in der ersten Schiebekette (I) alle das gesamte Schieberegister bildenden Verriegelungsschaltungen (MLT1 bis MLT8) enthalten sind, daß in der zweiten Schiebekette (II) nur jede zweite Verriegelungsschaltung (MLT2, MLT4, MLT6, ...) enthalten ist und daß in der n-ten Schiebekette (z. B. III) nur noch jede $2^{n-1}$-te Verriegelungsschaltung (MLT4 und MLT8) enthalten ist.

2. Schieberegister nach Anspruch 1, dadurch gekennzeichnet, daß durch eine vorgeschaltete Logikschaltung (00, 01, 10) und Treiberschaltungen die Selektion der zu einer jeweiligen Kette gehörenden Verriegelungsschaltungen (MLT) sowie der zugehörigen Schiebetaktimpulse (CL1 und/oder CL2) dadurch erfolgt, daß an die Eingänge dieser Schaltungen Steuersignale (Test Gate 0 und Test Gate 1) gelegt sind und die Ausgänge dieser Schaltungen mit ausgewählten, jeweils eine Schiebekette bildenden Verriegelungsschaltungen (MTL) verbunden sind.

3. Schieberegister nach den Ansprüchen 1 und 2, dadurch gekennzeichnet, daß den Eingängen der Hauptverriegelungs-Schaltungen bzw. Verriegelungsschaltungen (MLT1 bis MLT8) UND-Schaltungen (&) vorgeschaltet sind, die außer den genannten Steuersignalen auch die Eingangsdaten, die funktionellen Taktsignale und die funktionellen Datenbits erhalten, indem sie mit den entsprechenden Leitungen verbunden sind.

4. Schieberegister nach den Ansprüchen 1 bis 3, dadurch gekennzeichnet, daß nur ein Schiebetakt (CL1 oder CL2) über die genannten Logikschaltungen und Treiber wirksam wird, indem nur die Ausgänge dieser Schaltung wirksam werden, die zu dem geradzahligen oder ungeradzahligen Takt gehören.

5. Schieberegister nach den Ansprüchen 1 bis 3, dadurch gekennzeichnet, daß eine als Hauptverriegelungs-Schaltung (z. B. MLT4) dienende Verriegelungsschaltung (MLT) für einen bestimmten selektierten Zeitpunkt für die zuerst verwendete Schiebekette des Schieberegisters eine physikalische Hilfsverriegelungs-Schaltung ist.

## Claims

1. Shift register for testing and checking purposes on storage and logic chips, the stored contents of which are shifted by clock pulses and which consists of latch circuits arranged on the storage and logic chip, respectively, characterized in that $2^n$ latch circuits (MTL) are connected in the form of cascaded n shift chains (I to n) such that the first shift chain (I) comprises all the latch circuits (MLT1 to MLT8) forming the complete shift register, that the second shift chain (II) comprises only every other latch circuit (MLT2, MLT4, MLT6, ...), and that the nth shift chain (e. g., III) comprises only every $2^{n-1th}$ latch circuit (MLT4 and MLT8).

2. Shift register according to claim 1, characterized in that the latch circuits (MLT) belonging to the respective chain as well as the associated shift clock pulses (CL1 and/or CL2) are selected by means of a connected logic circuit (00, 01, 10) and driver circuits by applying control signals (test gate 0 and test gate 1) to the inputs of said circuits and by the outputs of said circuits being connected to selected ones of the latch circuits (MLT) each forming one shift chain.

3. Shift register according to claims 1 and 2, characterized in that the inputs of the master latch circuits and the latch circuits, respectively, (MLT1 to MLT8) are preceded by AND circuits (&) which, by being connected to the respective lines, receive functional clock signals and functional data bits, in addition to said control signals.

4. Shift register according to claims 1 to 3, characterized in that only one shift clock (CL1 or CL2) becomes active through said logic circuits and drivers by only those outputs of said circuit becoming active which are associated with the even- or odd- numbered clock.

5. Shift register according to claims 1 to 3, characterized in that a latch circuit (MLT), acting as master latch circuit (e. g., MLT4), is a physical slave latch circuit at a particular selecter time for the initially used shift chain of the shift register.

## Revendications

1. Registre à décalage conçu à des fins de contrôle et de test pour des microplaquettes de mémoire et de logique, dont les données emmagasinées sont décalées par des impulsions d'horloge, et dont les bascules à verrouillage se trouvent déjà sur la microplaquette de mémoire et de logique, caractérisé en ce que $2^n$ bascules à verrouillage (MLT) sont agencées en n chaînes de décalage (I à n) selon le principe du montage en cascade de telle sorte que la première chaîne de décalage (I) comprenne toutes les bascules à verrouillage (MLT1 à MLT8) de l'ensemble du registre à décalage, que la deuxième chaîne de décalage (II) ne comprenne plus qu'une bascule à verrouillage sur deux (MLT2, MLT4, MLT6, ...) et, que la chaîne de décalage n (III) ne comprenne plus que les $2^{n-1}$ èmes bascules à verrouillage (MLT4 et MLT8).

2. Registre à décalage selon la revendication 1, caractérisé en ce que les bascules à verrouillage (MLT) affectées à chacune des chaînes de décalage et les impulsions d'horloge de décalage respectives (CL1 et/ou CL2) sont sélectionnées, en appliquant aux entrées, d'une part, d'un circuit logique (00, 01, 10) monté en aval et, d'autre part, de circuits d'excitation, des signaux de commande (porte de test 0 et porte de test 1) et, en connectant les sorties desdits circuits aux bascules à verrouillage (MLT) sélectionnées qui constituent chaque fois une chaîne de décalage.

3. Registre à décalage selon les revendications 1 et 2, caractérisé en ce que des circuits ET (&) sont montés en aval des entrées des bascules à verrouillage principal (ou maîtres et des bascules à verrouillage (MLT1 à MLT8), ces circuits ET recevant, à travers leurs lignes de connexion respectives, non seulement les signaux de commande mentionnés ci-dessus mais aussi les données d'entrée, les signaux d'horloge de fonction et les bits de fonction.

4. Registre à décalage selon les revendications 1 à 3, caractérisé en ce qu'un seul signal à décalage (CL1 ou CL2) est initialisé à travers les circuits logiques et les circuits d'excitation mentionnés ci-dessus, en ne rendant actives que les sorties dudit circuit qui reçoivent les signaux pairs ou impairs.

5. Registre à décalage selon les revendications 1 à 3, caractérisé en ce qu'une simple bascule à verrouillage (MLT) utilisée en tant que bascule à verrouillage principal (par exemple MLT4) devient pour une période donnée choisie une bascule à verrouillage auxiliaire physique de la chaîne de décalage du registre qui est exploitée en premier.

**FIG. 1**

**FIG. 4**

FIG. 2

0 046 500

FIG. 3

FIG. 5